# EUROPEAN PATENT APPLICATION

(11) **EP 4 716 056 A1**
(43) Date of publication of application: **25.03.2026**
(21) Application number: 25182203.7
(22) Date of filing: 12.06.2025
(51) Int. Cl.: H02J 7/00, H01M 10/42

(54) **HIGH-VOLTAGE BOX, BATTERY CLUSTER, AND ENERGY STORAGE SYSTEM**

(30) Priority: 23.09.2024 CN 202422322598 U; 27.11.2024 WO PCT/CN2024/134733
(71) Applicant: Eve Energy Storage Co., Ltd, Wuhan, Hubei 430074 (CN)
(72) Inventor: ZHOU, Kai, Wuhan, Hubei 430074 (CN); SUN, Yuanbiao, Wuhan, Hubei 430074 (CN); ZHAO, Zihui, Wuhan, Hubei 430074 (CN)
(74) Representative: Berggren Oy

(57) **Abstract**

A high-voltage box (110), a battery cluster (100), and an energy storage system (10) are provided. The high-voltage box (110) includes a first interface (B+), a second interface (B-), a third interface (P+), a fourth interface (P-), a first fuse (FU1), and a main control module (111). The third interface (P+) is electrically connected to the battery pack (120) through the first fuse (FU1) and the first interface (B+) in sequence. Two ends of the second interface (B-) are electrically connected to the battery pack (120) and the fourth interface (P-), respectively. The main control module (111) includes a voltage acquisition module (101), one end of the voltage acquisition module (101) is electrically connected to a first node (M), and the other end of the voltage acquisition module (101) is electrically connected to a second node (N).

## Description

### Technical Field

The present application relates to a field of energy storage technology, and more specifically, to a high-voltage box, a battery cluster, and an energy storage system.

### Related Art

A high-voltage box is a device utilized in power systems, primarily designed to integrate and control various high-voltage components, ensuring the system's safe operation. In energy storage systems, the high-voltage box acts as an intermediary unit connecting the battery cluster and the inverter, offering functionalities including voltage/current acquisition, contactor control, and protection. Furthermore, the high-voltage box in the energy storage systems also facilitates the acquisition of individual battery cell voltage and temperature, alongside managing balance and providing alarm features.

### SUMMARY

However, the high-voltage box exhibits poor accuracy in high-voltage acquisition in energy storage systems.

In a first aspect, the present application provides a high-voltage box, including:
a first interface, one end of the first interface electrically connected to one end of a battery pack;
a second interface, one end of the second interface electrically connected to the other end of the battery pack;
a first fuse, one end of the first fuse electrically connected to the other end of the first interface to form a first node;
a third interface electrically connected to the other end of the first fuse;
a fourth interface electrically connected to the other end of the second interface to form a second node; and
a main control module including a voltage acquisition module, one end of the voltage acquisition module electrically connected to the first node, and the other end of the voltage acquisition module electrically connected to the second node.

In a second aspect, the present application further provides a battery cluster, including at least one battery pack and a high-voltage box described in the first aspect.

In a third aspect, the present application further provides an energy storage system, including a busbar cabinet and at least one battery cluster described in the second aspect;
wherein one end of the third interface is electrically connected to the other end of the first fuse, one end of the fourth interface is electrically connected to the other end of the second interface, and the other end of the third interface and the other end of the fourth interface are electrically connected to the busbar cabinet.

The high-voltage box provided by the present application includes a first interface, a second interface, a third interface, a fourth interface, a first fuse, and a main control module. One end of the first interface is electrically connected to one end of the battery pack; one end of the second interface is electrically connected to the other end of the battery pack; one end of the first fuse is electrically connected to the other end of the first interface to form a first node; the third interface is electrically connected to the other end of the first fuse; the fourth interface is electrically connected to the other end of the second interface to form a second node; the main control module includes a voltage acquisition module, one end of the voltage acquisition module is electrically connected to the first node, and the other end of the voltage acquisition module is electrically connected to the second node. Therefore, the present application can maintain the accuracy of high-voltage acquisition after the main positive fuse in the high-voltage box ages. At the same time, it can ensure that the energy storage system can accurately perform high-voltage measurement under both normal and fault conditions, which is beneficial for on-site maintenance personnel to inspect and troubleshoot, and greatly improves the reliability of the high-voltage box.

### BRIEF DESCRIPTION OF THE DRAWINGS

FIG. 1 is a first schematic block diagram of a battery cluster provided by the present application.
FIG. 2 is an equivalent circuit diagram of voltage acquisition according to the present application.
FIG. 3 is another equivalent circuit diagram of voltage acquisition according to the present application.
FIG. 4 is a second schematic block diagram of the battery cluster as provided in the present application.
FIG. 5 is a schematic diagram of an energy storage system as provided in the present application.

### Explanation of Reference Symbols in the Drawings

100: battery cluster; 110: high-voltage box; 120: battery pack; 200: busbar cabinet; R1: precharge resistor; K1: disconnect switch; KA1: first relay; KA2: second relay; KA3: precharge relay; FU1: first fuse; FU2: second fuse; Hall: Hall effect sensor; RW: current shunt; B+: first interface; B-: second interface; P+: third interface; P-: fourth interface; M: first node; N: second node; MBMU: main control board; SBMU: master control board; VCMU: slave control board..

### DETAILED DESCRIPTION

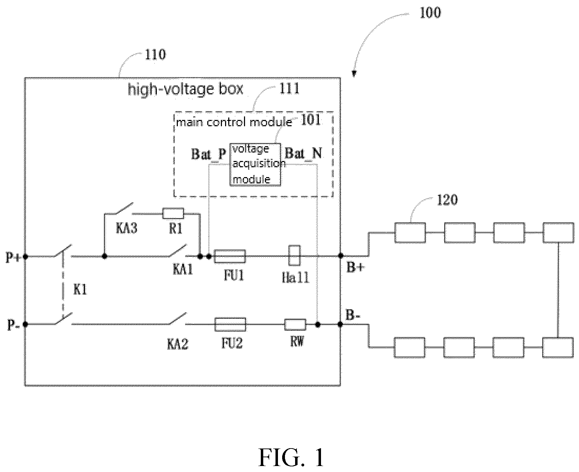

In some embodiments, as shown in FIG. 1, in the electrical design of a high-voltage box 110 of an energy storage system 10, a master control board SBMU is provided within the high-voltage box 110. The master control board SBMU is electrically connected to a first interface B+ and a second interface B- of the high-voltage box 110 to perform high-voltage measurement for the battery cluster 100 where the high-voltage box 110 is located. Two voltage acquisition lines are arranged on busbars of the first interface B+ and the second interface B-, respectively. One voltage acquisition line, serving as the power ground for voltage acquisition, is typically positioned near the second interface B- of the high-voltage box 110. The other voltage acquisition line, although lacking specific theoretical justification, is commonly placed between a main positive relay and a main positive fuse.

Under normal operating conditions, the internal resistance of the main positive fuse is very small, typically in the milliohm range. This resistance is insignificant compared to the line resistance and the internal resistance of the series-connected batteries. Therefore, in the series circuit configured for total voltage measurement, the total voltage measured by the master control board SBMU essentially represents the total battery voltage.

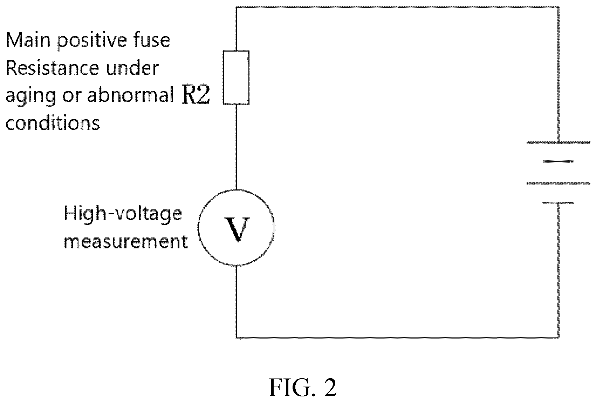

However, as the main positive fuse ages and its resistance increases, or in extreme cases, if the main positive fuse blows due to overload or short-circuit current in the circuit, its resistance after blowing can reach megaohms. In this case, the voltage drop across the main positive fuse in the series circuit for high-voltage measurement by the main control board SBMU needs to be considered. As shown in FIG. 2, calculations reveal that the series battery voltage measured by the main control board SBMU in such instances becomes significantly lower than the actual value, failing to represent the true voltage across the series-connected batteries.

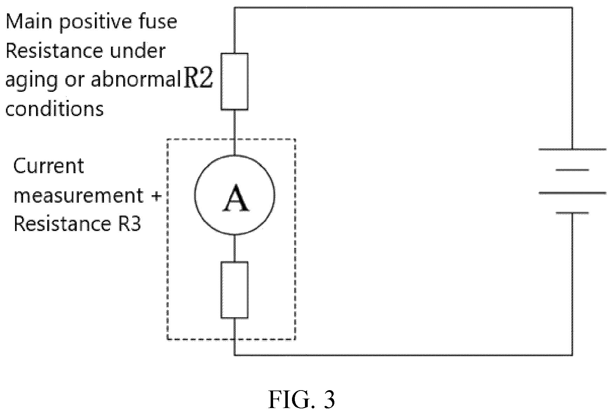

Based on the principle of voltage measurement, the equivalent circuit is shown in FIG. 3. The resistance of the main positive fuse under aging or abnormal blowing conditions can be represented by a resistance R2. The measured high-voltage value V is calculated as V = R3/(R3+R2) * U. If R2 = 6 MΩ and R3 = 5.11 MΩ, then V = 5.11/(5.11+6) * U = 0.46U. This shows that the measured voltage value V differs significantly from the actual battery voltage U.

In some embodiments, the present application provides a battery cluster 100 designed to maintain the accuracy of high-voltage measurement. This is achieved by placing the voltage acquisition point at the main positive fuse, specifically between the main positive fuse and the first interface B+. This design ensures accurate high-voltage measurement regardless of whether the main positive fuse in the high-voltage box 110 has aged or the energy storage system 10 is under normal or fault conditions. This accuracy is beneficial for on-site maintenance personnel, facilitating inspection, troubleshooting, and significantly improving the reliability of the high-voltage box 110.

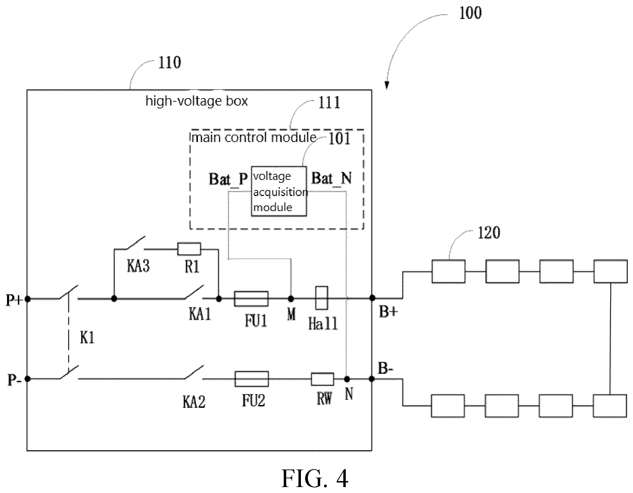

Please refer to FIG. 4, which is a second schematic block diagram of the battery cluster 100 provided by the present application.

As shown in FIG. 4, the present application provides a high-voltage box 110, which includes:
a first interface B+, one end of the first interface B+ is electrically connected to one end of a battery pack 120;
a second interface B-, one end of the second interface B- is electrically connected to the other end of the battery pack 120;
a first fuse FU1, one end of the first fuse FU1 is electrically connected to the other end of the first interface B+ to form a first node M;
a third interface P+, electrically connected to the other end of the first fuse FU1;
a fourth interface P-, electrically connected to the other end of the second interface B- to form a second node N;
a main control module 111, including a voltage acquisition module 101, one end of the voltage acquisition module 101 is electrically connected to the first node M, and the other end of the voltage acquisition module 101 is electrically connected to the second node N.

In this embodiment, the high-voltage box 110 is provided with four interfaces, namely, the first interface B+, the second interface B-, the third interface P+, and the fourth interface P-. The first interface B+ and the second interface B- are configured to be electrically connected to the battery pack 120 on the battery cluster 100 to achieve charging and discharging of the battery pack 120. The third interface P+ and the fourth interface Pare configured to be electrically connected to a target device, which can be a busbar cabinet 200 or an energy storage converter.

At the same time, the first fuse FU1, i.e., the main positive fuse, is arranged between the first interface B+ and the third interface P+. The main control module 111 of a battery management system, i.e., the main control board SBMU, is provided within the high-voltage box 110. The main control module 111 is provided with the voltage acquisition module 101 which is configured for high-voltage measurement of the battery cluster 100. The voltage acquisition module 101 is provided with two voltage acquisition lines. One voltage acquisition line is arranged between the first fuse FU1 and the first interface B+, i.e., electrically connected to the first node M. The other voltage acquisition line is arranged between the second interface B- and the fourth interface P-, i.e., electrically connected to the second node N. This design can maintain the accuracy of high-voltage measurement after the main positive fuse in the high-voltage box 110 ages. At the same time, it can ensure that the energy storage system 10 can accurately perform high-voltage measurement under both normal and fault conditions, which is beneficial for on-site maintenance personnel to inspect and troubleshoot, and greatly improves the reliability of the high-voltage box 110.

The high-voltage box 110 provided by the present application includes the first interface B+, the second interface B-, the third interface P+, the fourth interface P-, the first fuse FU1, and the main control module 111. One end of the first interface B+ is electrically connected to one end of the battery pack 120; one end of the second interface B- is electrically connected to the other end of the battery pack 120; one end of the first fuse FU1 is electrically connected to the other end of the first interface B+ to form a first node M; the third interface P+ is electrically connected to the other end of the first fuse FU1; the fourth interface P- is electrically connected to the other end of the second interface B- to form a second node N; the main control module 111 includes a voltage acquisition module 101, one end of the voltage acquisition module 101 is electrically connected to the first node M, and the other end of the voltage acquisition module 101 is electrically connected to the second node N, which can maintain the accuracy of high-voltage acquisition after the main positive fuse in the high-voltage box 110 ages. At the same time, it can ensure that the energy storage system 10 can accurately perform high-voltage acquisition under both normal and fault conditions, which is beneficial for on-site maintenance personnel to inspect and troubleshoot, and greatly improves the reliability of the high-voltage box 110.

In some embodiments, as shown in FIG. 4, the high-voltage box 110 further includes a second fuse FU2; wherein, one end of the second fuse FU2 is electrically connected to the other end of the second interface B- to form the second node N; the other end of the second fuse FU2 is electrically connected to the fourth interface P-.

In this embodiment, the second fuse FU2 is the main negative fuse in the high-voltage box 110. The main negative fuse is electrically connected to the second interface B-, forming the second node N. This configuration ensures that the accuracy of high-voltage measurements is maintained even as the main negative fuse ages.

In some embodiments, as shown in FIG. 4, the high-voltage box 110 further includes a Hall effect sensor Hall. One end of the Hall effect sensor Hall is electrically connected to the other end of the first interface B+, and the other end of the Hall effect sensor Hall is electrically connected to one end of the first fuse FU1 to form the first node M.

The Hall effect sensor Hall is a magnetic field sensor based on the Hall effect, widely used in various fields such as industrial automation, automotive electronics, computers, and information technology. Its working principle, known as the Hall effect, involves passing a current through a thin sheet of semiconductor material. This generates a potential difference perpendicular to the current and the magnetic field. Depending on the application, Hall effect sensors Hall can be categorized into various types, including linear Hall effect sensors, switching Hall effect sensors Hall, and magnetoresistive Hall effect sensors. Linear Hall effect sensors output analog voltage or current signals proportional to the magnetic induction intensity, making them suitable for applications requiring continuous magnetic field change measurement; while switching Hall effect sensors detect specific magnetic field thresholds, triggering switching actions upon reaching those thresholds.

In this embodiment, the first node M is positioned between the Hall effect sensor Hall and the first fuse FU1. Since the Hall effect sensor Hall has no direct electrical connection with the high-voltage busbar, its aging or device failure does not affect the high-voltage measurement function of the main control board SBMU. Therefore, whether the first node M is positioned on either side of the Hall effect sensor Hall has no impact on the high-voltage measurement by the voltage acquisition module 101.

In some embodiments, as shown in FIG. 4, the high-voltage box 110 further includes a current shunt RW. One end of the current shunt RW is electrically connected to the other end of the second interface B- to form the second node N, and the other end of the current shunt RW is electrically connected to one end of the second fuse FU2.

In this embodiment, to accurately acquire the voltage of the batteries in the battery cluster 100, the second node N needs to be located between the current shunt RW and the second interface B-. The current shunt RW is an electronic device used for current measurement and control. Its main function is to generate a low-resistance path through a low-value resistor, thereby diverting part of the current to another point in the circuit. This enables the current shunt RW to expand the measurement range of a current meter. Current shunts are often used in high-current detection applications, such as overcurrent protection, 4-20mA systems, and battery charging. The working principle of the current shunt RW is based on the principle that a DC current generates a voltage across a resistor when passing through it. When current flows through the current shunt RW, a certain voltage drop is generated across it. By measuring this voltage drop, the total current flowing through the entire circuit can be indirectly measured. For example, in a power battery pack, the current shunt RW is used to detect the current flowing through it, which is usually monitored by converting it into voltage.

In addition, current shunts RW come in various types and specifications. Common current shunts RW include manganese-nickel-copper alloy resistance bars and copper strips, plated with a nickel layer. The rated voltage drop is generally 60mV, but it can also be made into different specifications such as 75mV, 100mV, 120mV, 150mV, and 300mV according to needs. Furthermore, current shunts RW can also be divided into built-in and external types. Built-in types are usually used for small devices, while external types are suitable for situations that require handling larger currents.

In some embodiments, as shown in FIG. 4, the high-voltage box 110 further includes a first relay KA1 and a second relay KA2. One end of the first relay KA1 is electrically connected to the other end of the first fuse FU1, and the other end of the first relay KA1 is electrically connected to the third interface P+. One end of the second relay KA2 is electrically connected to the other end of the second interface B-, and the other end of the second relay KA2 is electrically connected to the fourth interface P-.

In this embodiment, the first relay KA1 is the main positive relay in the high-voltage box 110, and the second relay KA2 is a main negative relay in the high-voltage box 110. The main positive relay and the main negative relay in the high-voltage box 110 play a crucial role in the battery system. The main positive relay and the main negative relay can be controlled by the vehicle controller through the battery management system to control the on-off state of the main circuit. For example, during the charging process, the battery management system is awakened, and the battery management system turns on the precharge relay KA3, then turns on the main positive relay and turn off the precharge relay KA3.

The main positive relay is primarily configured as a control switch for the circuit, converting low-voltage signals into high-voltage signals to manage the switching of high-power electrical equipment. The working principle of the main positive relay is to utilize electromagnetic attraction. When the control circuit is powered, the coil of the main positive relay generates a magnetic field, attracting and activating the mechanical structure, thereby achieving switching action. In addition, the main positive relay serves a protective role in the circuit, providing critical safeguards. The main negative relay is mainly responsible for overload protection. When the current in the circuit exceeds the set rated value, the main negative relay automatically disconnects the circuit to prevent excessive current from causing equipment damage or fire hazards. The main negative relay determines whether the rated value is exceeded by measuring the current magnitude and takes timely measures to disconnect the circuit. Therefore, the main positive relay and the main negative relay in the high-voltage box 110 are responsible for the switching control and overload protection of the circuit respectively, which can ensure the safe operation of the battery system.

In some embodiments, as shown in FIG. 4, the high-voltage box 110 further includes a precharge circuit. One end of the precharge circuit is electrically connected to one end of the first relay KA1 and the other end of the first fuse FU1. The other end of the precharge circuit is electrically connected to the other end of the first relay KA1 and the third interface P+.

In this embodiment, the main function of the precharge circuit is to protect the battery and other electrical components by controlling the flow of current. Specifically, the precharge circuit can limit the charging current, prevent inrush current, reduce arcing, protect the main relay, and control the rate of voltage increase.

Specifically, within the high-voltage box 110, a precharge resistor is connected between the positive terminal of the battery and the battery positive relay, forming a series circuit. When the energy storage system 10 is turned on, the voltage of the battery starts to rise, and the high resistance of the resistor limits the current flow, thereby slowing down the rate of voltage increase.

The precharge circuit controls the slope of the charging current, allowing the battery to slowly absorb energy during the initial stage of charging and preventing inrush current. This helps protect the internal structure of the battery, extend battery life, and improve the stability of the entire charging system. At the same time, the precharging process can also reduce the occurrence of arcing when the high-voltage relay closes, avoid damage to high-voltage components due to high-voltage surges, and improve the safety of the high-voltage system. In addition, the precharge circuit can reduce the inrush current when power is turned on, protecting key components such as the battery and the main relay.

In some embodiments, as shown in FIG. 4, the precharge circuit includes a precharge relay KA3 and a precharge resistor R1. One end of the precharge relay KA3 is electrically connected to the other end of the precharge resistor R1, and the other end of the precharge relay KA3 is electrically connected to the third interface P+ and the other end of the first relay KA1. The other end of the precharge resistor R1 is electrically connected to one end of the first relay KA1 and the other end of the first fuse FU1.

Specifically, the precharge resistor R1 is a high-resistance component, and the function of the precharge resistor R1 is to control the voltage rise rate of the system by limiting the current flow. In the energy storage high-voltage box 110, the working principle of the precharge resistor R1 is to limit the charging current of the energy storage box during the precharge stage, avoiding excessive current that instantly generates arcing or overcurrent, thereby protecting the safe operation of the battery and the power system.

In some embodiments, as shown in FIG. 4, the high-voltage box 110 further includes a disconnect switch K1. A first end of the disconnect switch K1 is electrically connected to the other end of the first relay KA1, a second end of the disconnect switch K1 is electrically connected to the other end of the second relay KA2, a third end of the disconnect switch K1 is electrically connected to the third interface P+, and a fourth end of the disconnect switch K1 is electrically connected to the fourth interface P-.

Specifically, the disconnect switch K1 is an important electrical device, mainly used to break or close a circuit under conditions where there is voltage but no load current, thereby ensuring safe isolation. The main function of the disconnect switch K1 is to isolate the energized equipment from those under power-off maintenance, creating a distinct separation that secures the safety of maintenance personnel.

At the same time, in a double-busbar wiring system, the disconnect switch K1 can cooperate with the circuit breaker to complete the busbar switching operation under equipotential conditions. In addition, the disconnect switch K1 can also be used to switch on or off no-load transformers, voltage transformers, lightning arresters, and small current circuits not exceeding 5A.

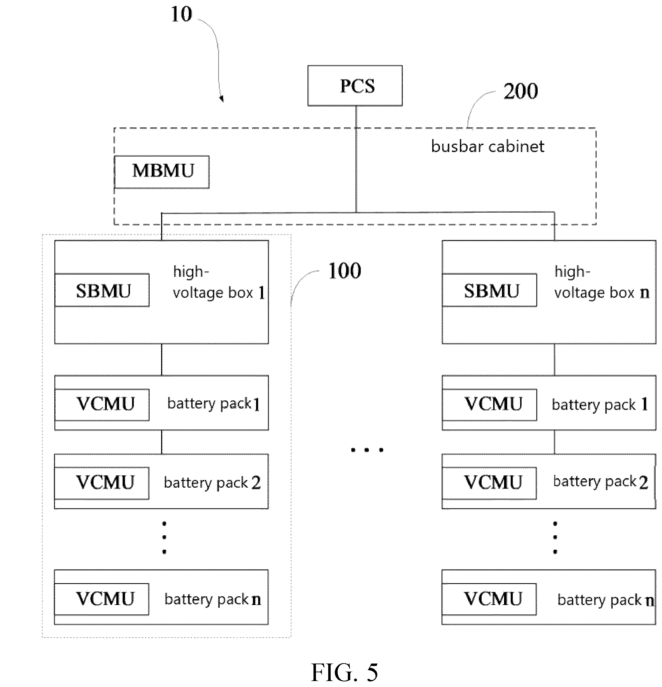

In some embodiments, as shown in FIG. 5, the present application also provides a battery cluster 100. The battery cluster 100 includes at least one battery pack 120 and a high-voltage box 110.

In this embodiment, the battery cluster 100 includes multiple battery packs 120 and the high-voltage box 110. The battery packs 120 can be individually identified as battery pack 1, battery pack 2, ..., battery pack n. After the battery packs 120 are connected in series, the battery packs 120 are electrically connected to the first interface B+ and the second interface B- of the high-voltage box 110. Each battery pack 120 is provided with a slave control board VCMU, and the high-voltage box 110 is provided with a main control board SBMU.

The master control board SBMU supports battery status data processing to manage and control the charging and discharging of the battery cluster 100. The master control board SBMU also supports cluster voltage and cluster current detection and supports real-time isolated acquisition and processing of the Hall effect sensor. Additionally, the master control board SBMU supports the insulation monitoring function, on-off detection function, single-cell SOC/SOH/SOE/SOP estimation, and cluster SOE, SOH estimation of the battery cluster 100. Moreover, the master control board SBMU also supports the thermal management control function, active thermal management, data storage function, local data logging of system operation data, and system scalability function. The system scalability includes multi-channel active/passive signal output. Furthermore, the master control board SBMU also supports firmware upgrade via Bootloader or remote upgrade.

The slave control board VCMU supports single-cell voltage and temperature monitoring, terminal temperature monitoring, CAN communication function, automatic addressing function, active/passive balancing function, and DO/DI signal transmission function.

In some embodiments, as shown in FIG. 5, the present application also provides an energy storage system 10. The energy storage system 10 includes a busbar cabinet 200 and at least one battery cluster 100. One end of the third interface P+ is electrically connected to the other end of the first fuse FU1, one end of the fourth interface P- is electrically connected to the other end of the second interface B-, and the other end of the third interface P+ and the other end of the fourth interface P- are both electrically connected to the busbar cabinet 200.

In this embodiment, the energy storage system 10 includes a plurality of battery clusters 100, a busbar cabinet 200, and a power conversion system (PCS). Each battery cluster 100 is provided with one of multiple high-voltage boxes 110, ranging from high-voltage box 1 to high-voltage box n. A main control board MBMU is provided within the busbar cabinet 200. The main control board MBMU supports real-time data access and display functions for multiple battery clusters 100 and also supports periodic data logging and generates alarms for overvoltage, undervoltage, overcurrent, overtemperature, voltage differences, temperature differences, and temperature rises. In addition, the master control board MBMU also supports protection, online insulation detection, fault detection, thermal management control, and protection functions, supports the configuration of network parameters and communication parameters, and supports the remote upgrade of the three-level BMS software.

## Claims

1. A high-voltage box (110), **characterized in that** comprises:
a first interface (B+), one end of the first interface (B+) electrically connected to one end of a battery pack (120);
a second interface (B-), one end of the second interface (B-) electrically connected to the other end of the battery pack (120);
a first fuse (FU1), one end of the first fuse (FU1) electrically connected to the other end of the first interface (B+) to form a first node (M);
a third interface (P+) electrically connected to the other end of the first fuse (FU1);
a fourth interface (P-) electrically connected to the other end of the second interface (B-) to form a second node (N); and
a main control module (111) comprising a voltage acquisition module (101), one end of the voltage acquisition module (101) electrically connected to the first node (M), and the other end of the voltage acquisition module (101) electrically connected to the second node (N).

2. The high-voltage box (110) according to claim 1, further comprising a second fuse (FU2), wherein one end of the second fuse (FU2) is electrically connected to the other end of the second interface (B-) to form the second node (N), and the other end of the second fuse (FU2) is electrically connected to the fourth interface (P-).

3. The high-voltage box (110) according to claim 1 or 2, further comprising a Hall effect sensor (Hall);
wherein one end of the Hall effect sensor (Hall) is electrically connected to the other end of the first interface (B+), and the other end of the Hall effect sensor (Hall) is electrically connected to one end of the first fuse (FU1) to form the first node (M).

4. The high-voltage box (110) according to any one of claims 1 to 3, further comprising a current shunt (RW);
wherein one end of the current shunt (RW) is electrically connected to the other end of the second interface (B-) to form the second node (N), and the other end of the current shunt (RW) is electrically connected to one end of the second fuse (FU2) when dependent on claim 2, or to the fourth interface (P-) when dependent on claim 1.

5. The high-voltage box (110) according to any one of claims 1 to 4, further comprising a first relay (KA1) and a second relay (KA2);
wherein one end of the first relay (KA1) is electrically connected to the other end of the first fuse (FU1), and the other end of the first relay (KA1) is electrically connected to the third interface (P+); and one end of the second relay (KA2) is electrically connected to the other end of the second interface (B-), and the other end of the second relay (KA2) is electrically connected to the fourth interface (P-).

6. The high-voltage box (110) according to claim 5, further comprising a precharge circuit;
wherein one end of the precharge circuit is electrically connected to one end of the first relay (KA1) and the other end of the first fuse (FU1); and the other end of the precharge circuit is electrically connected to the other end of the first relay (KA1) and the third interface (P+).

7. The high-voltage box (110) according to claim 6, wherein the precharge circuit comprises a precharge relay (KA3) and a precharge resistor (R1);
one end of the precharge relay (KA3) is electrically connected to the other end of the precharge resistor (R1), and the other end of the precharge relay (KA3) is electrically connected to the third interface (P+) and the other end of the first relay (KA1); and one end of the precharge resistor (R1) is electrically connected to one end of the first relay (KA1) and the other end of the first fuse (FU1).

8. The high-voltage box (110) according to any one of claims 5 to 7, further comprising a disconnect switch (K1);
wherein a first end of the disconnect switch (K1) is electrically connected to the other end of the first relay (KA1), a second end of the disconnect switch (K1) is electrically connected to the other end of the second relay (KA2), a third end of the disconnect switch (K1) is electrically connected to the third interface (P+), and a fourth end of the disconnect switch (K1) is electrically connected to the fourth interface (P-).

9. A battery cluster (100) comprising at least one battery pack (120) and a high-voltage box (110), the high-voltage box (110) **characterized in that** comprises:
a first interface (B+), one end of the first interface (B+) electrically connected to one end of a battery pack (120);
a second interface (B-), one end of the second interface (B-) electrically connected to the other end of the battery pack (120);
a first fuse (FU1), one end of the first fuse (FU1) electrically connected to the other end of the first interface (B+) to form a first node (M);
a third interface (P+) electrically connected to the other end of the first fuse (FU1);
a fourth interface (P-) electrically connected to the other end of the second interface (B-) to form a second node (N); and
a main control module (111) comprising a voltage acquisition module (101), one end of the voltage acquisition module (101) electrically connected to the first node (M), and the other end of the voltage acquisition module (101) electrically connected to the second node (N).

10. The battery cluster (100) according to claim 9, wherein the high-voltage box (110) further comprises a second fuse (FU2), wherein one end of the second fuse (FU2) is electrically connected to the other end of the second interface (B-) to form the second node (N), and the other end of the second fuse (FU2) is electrically connected to the fourth interface (P-).

11. The battery cluster (100) according to claim 9 or 10, wherein the high-voltage box (110) further comprises a Hall effect sensor (Hall);
wherein one end of the Hall effect sensor (Hall) is electrically connected to the other end of the first interface (B+), and the other end of the Hall effect sensor (Hall) is electrically connected to one end of the first fuse (FU1) to form the first node (M).

12. The battery cluster (100) according to any one of claims 9 to 11, wherein the high-voltage box (110) further comprises a first relay (KA1) and a second relay (KA2);
wherein one end of the first relay (KA1) is electrically connected to the other end of the first fuse (FU1), and the other end of the first relay (KA1) is electrically connected to the third interface (P+); and one end of the second relay (KA2) is electrically connected to the other end of the second interface (B-), or to the other end of the second fuse (FU2) when dependent on claim 10, and the other end of the second relay (KA2) is electrically connected to the fourth interface (P-).

13. The battery cluster (100) according to any one of claims 9 to 12, further comprising a slave control board (VCMU) in each battery pack (120) and a master control board (SBMU) in the high-voltage box (110), wherein the master control board (SBMU) is configured to manage charging and discharging of the battery cluster (100) based on data from the voltage acquisition module (101).

14. The battery cluster (100) according to any one of claims 12 to 13, wherein the high-voltage box (110) further comprising a precharge circuit;
wherein one end of the precharge circuit is electrically connected to one end of the first relay (KA1) and the other end of the first fuse (FU1); and the other end of the precharge circuit is electrically connected to the other end of the first relay (KA1) and the third interface (P+).

15. An energy storage system (10) **characterized in that** comprises a busbar cabinet (200) and at least one battery cluster (100) of claim 9;
wherein one end of the third interface (P+) is electrically connected to the other end of the first fuse (FU1), one end of the fourth interface (P-) is electrically connected to the other end of the second interface (B-), and the other end of the third interface (P+) and the other end of the fourth interface (P-) are electrically connected to the busbar cabinet (200).
